# EUROPÄISCHE PATENTSCHRIFT

(11) **EP 2 633 623 B1**
(45) Veröffentlichungstag und Bekanntmachung des Hinweises auf die Patenterteilung: **26.09.2018**
(21) Anmeldenummer: 11776749.1
(22) Anmeldetag: 26.10.2011
(51) Int. Cl.: H03K 17/95, H03K 17/00

(54) **INDUKTIVER NAEHERUNGSSCHALTER**
INDUCTIVE PROXIMITY SENSOR
COMMUTATEUR DE PROXIMITÉ INDUCTIF

(30) Priorität: 27.10.2010 DE 102010043009
(43) Veröffentlichungstag der Anmeldung: 04.09.2013
(73) Patentinhaber: IFM Electronic GmbH, 45128 Essen (DE)
(72) Erfinder: GUNDLACH, Jochen, 88079 Kressbronn (DE)
(86) Internationale Anmeldenummer: PCT/EP2011/068755
(87) Internationale Veröffentlichungsnummer: WO 2012/055914

(56) Entgegenhaltungen:
- EP-A1- 2 348 637
- EP-A2- 1 347 311
- DE-A1- 10 003 913

## Beschreibung

Die Erfindung betrifft einen induktiven Näherungsschalter gemäß den Merkmalen des Oberbegriffs des Patentanspruchs 1, sowie ein Verfahren zum Betreiben des erfindungsgemäßen induktiven Näherungsschalters nach Anspruch 4.

Induktive Näherungsschalter werden als berührungslos arbeitende elektronische Schaltgeräte vor allem in der Automatisierungstechnik eingesetzt.

Sie enthalten eine Sendespule, die ein elektromagnetisches von einem metallischen Auslöser beeinflussbares Magnetfeld erzeugt. Die Beeinflussung des Magnetfeldes durch den metallischen Auslöser (Schaltfahne) wird ausgewertet und bei Überschreiten eines Schwellwerts eine elektronische Schaltstufe angesteuert. Schaltgeräte dieser Art werden in den verschiedensten Ausführungen unter anderem auch von der Anmelderin hergestellt und vertrieben.

Hierbei kann sowohl die Ansteuerung der Sendespule als auch die Bewertung des Einflusses des metallischen Auslösers auf unterschiedliche Art erfolgen.

In vielen Fällen ist die Sendespule Bestandteil eines Oszillators, der durch den metallischen Auslöser verstimmt wird. Ausgewertet wird die Amplitude und/oder die Frequenzänderung.

Neben der weit verbreiteten sinusförmigen Ansteuerung der Sendespule und der Bewertung von Frequenz- und oder Amplitudenänderungen ist die Ansteuerung mit kurzen Sendeimpulsen bekannt. Die Sendespule ist in diesem Fall nicht Bestandteil eines Oszillators, sondern sie wird mit kräftigen, meist rechteckförmigen Spannungs- bzw. Stromimpulsen beaufschlagt. Der durch die im metallischen Auslöser hervorgerufenen Wirbelströme ausgelöste Echoimpuls wird ausgewertet.

Empfangs- und Sendespule bilden in diesem Fall einen durch die Wirbelströme im metallischen Auslöser beeinflussten Transformator. Eine solche Anordnung wird in der DE10003913A1 gezeigt. Eine wirksame Unterdrückung des Sendepulses wird in bekannter Weise durch zwei gegensinnig in Reihe geschaltete Empfangspulen erreicht, wobei eine der beiden Empfangsspulen dem metallischen Auslöser zugewandt und die andere Empfangsspule dem metallischen Auslöser abgewandt ist. Ausgewertet wird das Differenzsignal der beiden Empfangsspulen. Man spricht in diesem Fall von einem Differentialtransformator.

Die Reichweite von induktiven Näherungsschaltern ist begrenzt, da ein geschlossener Schwingkreis bzw. ein geschlossener Spulenstromkreis naturgemäß nur wenig Energie abstrahlt. Die Wechselwirkung mit dem metallischen Auslöser (Target) ist auf das Nahfeld beschränkt. Sie nimmt etwa mit der 3-fachen Potenz des Schaltabstandes ab.

Das Problem verschärft sich bei induktiven Ganzmetallschaltern, weil hier durch die metallische Gehäusewand hindurch gemessen werden muss. Die metallische Gehäusewand stellt somit ein zusätzliches zweites Target dar.

Weiterhin werden die Sensoreigenschaften erheblich durch die Einbaulage in einer metallischen oder in einer nichtmetallischen Halterung beeinflusst.

Die EP 1 347 311 A2 offenbart ein Verfahren und eine Anordnung zum Detektieren von Metallobjekten mit einem Differentialtransformator, der von einem Pulsgenerator mit einem Rechtecksignal versorgt wird. Unter anderem wird hier vorgeschlagen, die beiden Empfangsspulen durch magnetoresistive Sensoren, insbesondere durch Hall-Sensoren zu ersetzen. Auf die elektromagnetischen Eigenschaften des Gehäuses oder gar deren Berücksichtigung wird in dieser Schrift nicht eingegangen.

Als nachteilig wird die mit den herkömmlichen Messprinzipien erzielbare geringe Reichweite angesehen, wie sie z.B. in der Norm IEC/EN 60947-5-2 angegeben sind. Obwohl es in der Vergangenheit einige erfolgreiche Verbesserungsansätze gegeben hat, wird ein wesentlicher Nachteil der bekannten technischen Lösungen darin gesehen, dass die Empfangsspule aufgrund des Induktionsgesetztes lediglich die Änderungen der im Target induzierten Wirbelströme nachweisen kann, nicht aber deren Gleichanteile, d.h. die zeitlich konstanten Wirbelstromanteile.

Aufgabe der Erfindung ist es, den Stand der Technik weiter zu entwickeln. Insbesondere bei Ganzmetallschaltern soll die Empfindlichkeit verbessert und damit auch der Schaltabstand erhöht werden.

Diese Aufgabe wird entsprechend den Merkmalen des Patentanspruchs 1 gelöst. Die Unteransprüche betreffen vorteilhafte Weiterbildungen der Erfindung.

Die wesentliche Idee der Erfindung besteht darin, das physikalische Wirkprinzip so zu verändern, dass nicht mehr wie bisher mit einer Empfangsspule die erste zeitliche Ableitung des durch die im Target fließenden Wirbelströme hervorgerufenen Magnetfeldes, sondern zusätzlich auch noch die niederfrequenten Anteile dieses sekundären Magnetfeldes ausgewertet werden.

Das geschieht erfindungsgemäß durch einen Magnetsensor, der im Gegensatz zur Empfangsspule nicht nur zeitliche Änderungen der magnetischen Induktion B, sondern auch Gleichanteile des sekundären B-Feldes auswerten kann.

Bei der weit verbreiteten Beaufschlagung mit Rechteckimpulsen tragen praktisch nur deren Kanten, d.h. die zeitliche Änderung des Flankenanstiegs des Sendestromes bzw. des Primär-Magnetfeldes zum Messergebnis bei. Bereiche mit einer im Wesentlichen konstanten zeitlichen Ableitung induzieren zwar Wirbelströme im Target, erzeugen aber mit ihren niederfrequenten Spektralanteilen nur wenig Signal in einer Empfangsspule.

Andererseits wirkt das Gehäuse eines Ganzmetallschalters als Tiefpass mit einer Grenzfrequenz von etwa 100 kHz. Die von schnellen Schaltflanken hervorgerufenen hochfrequenten Magnetfeldanteile können also gar nicht bis zum Target gelangen und somit auch nicht zum Messergebnis beitragen. Deshalb wird erfindungsgemäß die Impulsform des Sendepulses an den Frequenzgang des Metallgehäuses angepasst.

Der Einsatz eines Magnetsensors ist besonders vorteilhaft, weil damit auch niedere Frequenzanteile, insbesondere die während einer ansteigenden oder abfallenden Flanke des Sendeimpulses über einen gewissen Zeitraum nahezu unveränderlichen Wirbelstromanteile ausgewertet werden können.

Die Erfindung wird anhand der Zeichnung näher erläutert.

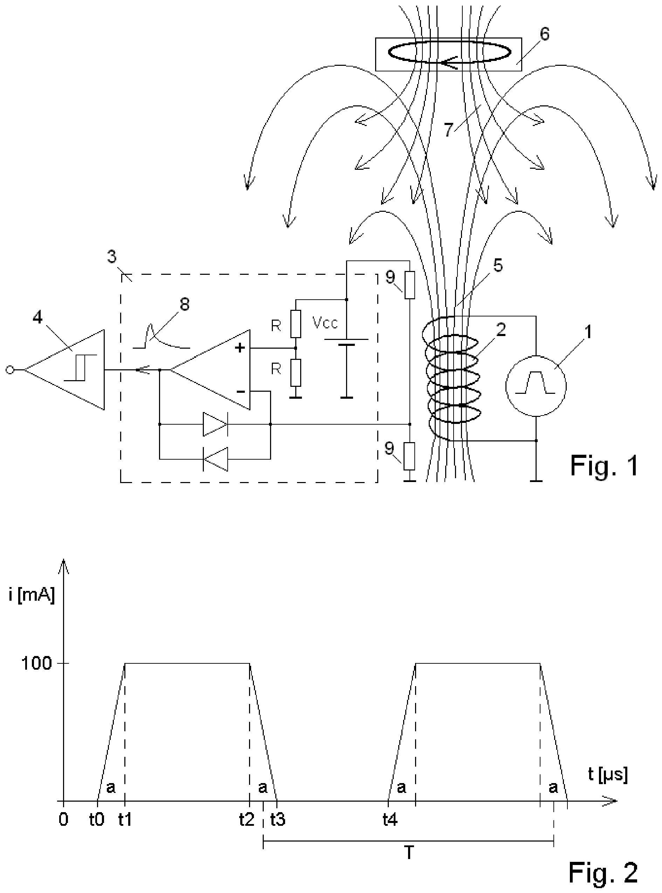

Die Fig. 1 zeigt die Prinzipschaltung für einen erfindungsgemäßen induktiven Näherungsschalter im Ganzmetallgehäuse. Die Pulsschaltung 1 bestromt die Sendespule 2. Der trapezförmige Verlauf des Sendepulses soll darauf hinweisen, dass wegen der oben erläuterten Tiefpasseigenschaften des Ganzmetallgehäuses bewusst auf hohe Frequenzanteile (>100kHz) verzichtet wird.

Das von der Sendespule erzeugte Primär-Magnetfeld 5 durchflutet das Target 6. Die dort induzierten Wirbelströme rufen das Sekundär-Magnetfeld 7 hervor.

Die Magnetsensoren 9 sind zur besseren Erkennbarkeit neben der Sendespule 2 gezeichnet. Wegen ihrer hohen Empfindlichkeit werden Giant-magnetoresistive Sensoren (GMR) eingesetzt. Sie sind so auf der Spulenachse angeordnet, dass einer der beiden stärker vom Sekundär-Magnetfeld 7 beeinflusst wird.

Zur Unterdrückung von Störsignalen bzw. zur besseren Separierung des Nutzsignals werden sie in einer Differenzschaltung betrieben, d.h. sie sind so angeordnet und verschaltet, dass der Einfluss des Primär-Magnetfeldes 5 kompensiert wird.

Die Empfangsschaltung 3 besteht im Wesentlichen aus einer Brückenschaltung und einem übersteuerungsfesten Verstärker. Zur Erzeugung eines binären Schaltsignals ist die Empfangseinheit 3 mit einer als Trigger dargestellten Auswerteschaltung 4 verbunden.

Die Fig. 2 verdeutlicht den Verlauf des Sendesignals. Es handelt sich um ein symmetrisches Rechtecksignal mit der typischen Periodenlänge T = 20 µs. Die mit a bezeichneten Impulsflanken sind überproportional dargestellt. Die Anstiegszeit t1-t0 und die Abfallzeit t3-t2 betragen jeweils nur etwa 0,1 µs. Selbstverständlich ist die Erfindung weder auf die gezeigte Impulsform noch auf die angegebenen Zeiten beschränkt. Die Impulsform wird erfindungsgemäß an den Frequenzgang des Metallgehäuses angepasst.

Da auch die Impulsflanken zum Messergebnis beitragen sollen, werden sie so gewählt, dass sowohl das Primär-Magnetfeld 5 als auch das vom Target 6 hervorgerufene Sekundär-Magnetfeld 7 das Metallgehäuse des Sensors durchdringen können.

Die Erfindung betrifft einen induktiven Näherungsschalter mit einer Pulsschaltung 1 zur Erzeugung eines Sendepulses, einer Sendespule 2 zur Erzeugung eines Primär-Magnetfeldes 5, einer Empfangseinheit 3 zur Auswertung eines Empfangssignals 8 und einer Auswerteschaltung 4 zur Erzeugung eines binären Schaltsignals, wobei das gepulste Primär-Magnetfeld 5 in einem elektrisch leitfähigen Target 6 einen Wirbelstrom hervorrufen kann, der ein veränderliches Sekundär-Magnetfeld 7 zur Folge hat. Die Empfangseinheit 3 ist mit einem Magnetsensor 9 zur Erfassung der magnetischen Flussdichte B des Sekundär-Magnetfeldes 7 verbunden.

Der Magnetsensor 9 weist vorteilhaft einen GMR-Sensor auf. Natürlich kann jeder andere Magnetsensor mit ausreichender Empfindlichkeit und Bandbreite eingesetzt werden. Insbesondere kommen den anisotropen magnetorestiven Effekt nutzende AMR-Sensoren oder Hall-Elemente (Hall-Sensoren) in Frage.

Da das Sekundär-Magnetfeld 7 notwendigerweise von dem Primär-Magnetfeld 5 überlagert ist, werden vorteilhaft zwei Magnetsensoren 9 so in Differenzschaltung angeordnet, dass sie mit gleicher Intensität vom Primär-Magnetfeld 5 und mit unterschiedlicher Intensität vom Sekundär-Magnetfeldes 7 durchflutet werden. Durch Auswertung ihres Differenzsignals wird das Primär-Magnetfeld 5 weitgehend unterdrückt und die Empfindlichkeit für das Sekundär-Magnetfeld 7 verbessert.

Die Erfindung betrifft weiterhin ein Verfahren zum Betreiben eines induktiven Näherungsschalters.

Mit einer Pulsschaltung 1 wird ein Sendepuls generiert und einer Sendespule 2 zugeführt. Dem dadurch erzeugten Primär-Magnetfeld 5 wird ein elektrisch leitfähiges Target 6 ausgesetzt.

Die vom Primär-Magnetfeld 5 im Target 6 erzeugten Wirbelströme generieren ein Sekundär-Magnetfeld 7. Das Sekundär-Magnetfeld 7 wird mit einem Magnetsensor 9 erfasst und mit einer Empfangseinheit 3 ausgewertet. Erfindungsgemäß werden die Frequenz des Sendepulses und/oder die Anstiegszeiten seiner Schaltflanken an die Grenzfrequenz des als Tiefpass wirkenden Metallgehäuses angepasst. So kann das Primär-Magnetfeld 5 das Metallgehäuse mit hohem Wirkungsgrad durchdringen. Somit wird die Sendeimpulsform und damit der Zeitverlauf des Primär-Magnetfeldes (5) zur besseren Durchdringung an die Grenzfrequenz des als Tiefpass wirkenden Metallgehäuses angepasst.

Da der Sendepuls zur Erzeugung des Primär-Magnetfeldes 5 Flanken mit nahezu konstanter zeitlicher Ableitung aufweist, entstehen niederfrequente Wirbelströme im Target und damit auch niederfrequente Anteile im Sekundär-Magnetfeld 7, die erfindungsgemäß mit einem Magnetsensor 9 ausgewertet werden Zur Unterdrückung von permanenten äußeren Magnetfeldern kann zusätzlich auch während einer Sendepause gemessen und die Differenz ausgewertet werden.

Weiterhin kann der zeitliche Verlauf des Sendepulses in einem Einlernvorgang mit einem in fast allen modernen Geräten eingesetzten Mikrocontroller optimiert werden. So wird das Spektrum des Sendepulses und damit auch des Primär-Magnetfeldes 5 besser an den Frequenzgang des metallischen Gehäuses angepasst.

Das kann durch Änderung der Periodenlänge T der Grundfrequenz, aber auch durch Verlängerung oder Verkürzung der Anstiegs- bzw. Abfallzeiten geschehen.

In einer vorteilhaften Ausgestaltung des Verfahrens werden zwei Magnetsensoren 9 in Differenzschaltung betrieben und mit der Empfangseinheit 3 auswertet. Sie werden so angeordnet, dass das Primär-Magnetfeld 5 gleichermaßen und das Sekundär-Magnetfeld 7 unterschiedlich auf die beiden Magnetsensoren 9 einwirkt. So werden beide Magnetsensoren 9 in gleicher Weise vom Primär-Magnetfeld 5 beeinflusst und einer der beiden Magnetsensoren 9 stärker von dem Sekundär-Magnetfeld 7 beeinflusst. Auf diese Weise wird das Primär-Magnetfeld 5 kompensiert und vorzugsweise das Sekundär-Magnetfeld 7 ausgewertet.

### Bezugszeichenliste

- 1: Pulsschaltung (Generator)
- 2: Sendespule
- 3: Empfangseinheit
- 4: Auswerteschaltung
- 5: Primär-Magnetfeld
- 6: Target, Schaltfahne, metallischer Auslöser
- 7: Sekundär-Magnetfeld
- 8: Ausgangssignal
- 9: Magnetsensor
- a: Impulsflanke
- B: Magnetische Flussdichte, Magnetische Induktion, Magnetfeld
- T: Periodenlänge

## Patentansprüche

1. Induktiver Näherungsschalter in einem Metallgehäuse mit einer Pulsschaltung (1) zur Generierung eines Sendepulses einer bestimmten Impulsform, einer Sendespule (2) zur Erzeugung eines Primär-Magnetfeldes (5) aus dem Sendepuls, einer Empfangseinheit (3) zur Auswertung eines Empfangssignals (8) und einer Auswerteschaltung (4) zur Erzeugung eines binären Schaltsignals, wobei das gepulste Primär-Magnetfeld (5) in einem elektrisch leitfähigen Target (6) einen Wirbelstrom hervorrufen kann, der ein veränderliches Sekundär-Magnetfeld (7) zur Folge hat, wobei die Empfangseinheit (3) mit einem Magnetsensor (9) verbunden ist, der die magnetischen Flussdichte des Sekundär-Magnetfeldes (7) erfasst, **dadurch gekennzeichnet, dass** die Impulsform an den Frequenzgang des Metallgehäuses des Näherungsschalters angepasst ist, sodass auch die Impulsflanken zum Messergebnis beitragen, welche deshalb so gewählt sind, dass sowohl das Primär-Magnetfeld (5) als auch das vom Target (6) hervorgerufene Sekundär-Magnetfeld (7) das als Tiefpass wirkende Metallgehäuse durchdringen können.

2. Induktiver Näherungsschalter nach Anspruch 1, **dadurch gekennzeichnet, dass** der Magnetsensor (9) einen GMR-, einen AMR- oder einen Hall-Sensor aufweist.

3. Induktiver Näherungsschalter nach Anspruch 1 oder 2, **dadurch gekennzeichnet, dass** ein symmetrisches Rechtecksignal mit einer typischen Periodenlänge T=20 µs ausgesendet wird, dessen Anstiegszeit t1-t0 und Abfallzeit t3-t2 jeweils etwa 0,1 µs beträgt.

4. Verfahren zum Betreiben eines induktiven Näherungsschalters mit einem Magnetsensor (9) in einem Metallgehäuse nach einem der vorhergehenden Ansprüche, wobei ein Sendepuls mit einer bestimmten Impulsform ein Primär-Magnetfeld (5) erzeugt, ein elektrisch leitfähiges Target (6) dem Magnetfeld ausgesetzt wird, das von den Wirbelströmen im Target (6) erzeugte Sekundär-Magnetfeld (7) erfasst und ausgewertet wird, **dadurch gekennzeichnet, dass** die Impulsform und damit der Zeitverlauf des Primär-Magnetfeldes (5) zur besseren Durchdringung des Metallgehäuses an die Grenzfrequenz des als Tiefpass wirkenden Metallgehäuses angepasst wird, und so die von den Impulsflanken erzeugten niederfrequenten Anteile des Sekundär-Magnetfeldes (7) mit dem Magnetsensor (9) ausgewertet werden.

## Claims

1. Inductive proximity switch in a metal housing, having a pulse circuit (1) for generating a transmission pulse of a particular pulse shape, a transmission coil (2) for generating a primary magnetic field (5) from the transmission pulse, a receiving unit (3) for evaluating a reception signal (8), and an evaluation circuit (4) for generating a binary switching signal, wherein the pulsed primary magnetic field (5) can cause an eddy current in an electrically conductive target (6), which eddy current results in a variable secondary magnetic field (7), wherein the receiving unit (3) is connected to a magnetic sensor (9) which captures the magnetic flux density of the secondary magnetic field (7), **characterized in that** the pulse shape is adapted to the frequency response of the metal housing of the proximity switch, with the result that the pulse edges also contribute to the measurement result and are therefore selected in such a manner that both the primary magnetic field (5) and the secondary magnetic field (7) caused by the target (6) can penetrate the metal housing acting as a low-pass filter.

2. Inductive proximity switch according to Claim 1, **characterized in that** the magnetic sensor (9) has a GMR, an AMR or a Hall sensor.

3. Inductive proximity switch according to Claim 1 or 2, **characterized in that** a symmetrical square-wave signal is emitted with a typical period length of T=20 µs, the rise time t1-t0 and fall time t3-t2 of which square-wave signal are each approximately 0.1 µs.

4. Method for operating an inductive proximity switch having a magnetic sensor (9) in a metal housing according to one of the preceding claims, wherein a transmission pulse having a particular pulse shape generates a primary magnetic field (5), an electrically conductive target (6) is exposed to the magnetic field, and the secondary magnetic field (7) generated by the eddy currents in the target (6) is captured and evaluated, **characterized in that** the pulse shape and therefore the time profile of the primary magnetic field (5) are adapted to the cutoff frequency of the metal housing acting as a low-pass filter for better penetration of the metal housing and the low-frequency components of the secondary magnetic field (7) which are generated by the pulse edges are thus evaluated using the magnetic sensor (9).

## Revendications

1. Détecteur de proximité inductif, placé dans un boîtier métallique, comprenant un circuit d'impulsions (1) destiné à générer une impulsion d'émission, une forme d'impulsion particulière, une bobine d'émission (2) destinée à générer un champ magnétique primaire (5) à partir de l'impulsion d'émission, une unité de réception (3) destinée à évaluer un signal de réception (8) et un circuit d'évaluation (4) destiné à générer un signal de commutation binaire,
le champ magnétique primaire pulsé (5) pouvant provoquer dans une cible électriquement conductrice (6) un courant de Foucault qui a pour conséquence un champ magnétique secondaire variable (7), l'unité de réception (3) étant reliée à un capteur magnétique (9) qui détecte la densité de flux magnétique du champ magnétique secondaire (7), **caractérisé en ce que** la forme d'impulsion est adaptée à la réponse en fréquence du boîtier métallique du détecteur de proximité de sorte que les fronts d'impulsion contribuent également au résultat de la mesure, lesquels sont pour cette raison choisis de telle sorte que le champ magnétique primaire (5) et le champ magnétique secondaire (7), provoqué par la cible (6), puissent pénétrer dans le boîtier métallique agissant comme un filtre passe-bas.

2. Détecteur de proximité inductif selon la revendication 1, **caractérisé en ce que** le capteur magnétique (9) comporte un capteur GMR, AMR ou à effet Hall.

3. Détecteur de proximité inductif selon la revendication 1 ou 2, **caractérisé en ce qu'**un signal carré symétrique est émis avec une durée caractéristique T = 20 µs, dont le temps de montée t1-t0 et le temps de descente t3-t2 étant d'environ 0,1 µs.

4. Procédé de fonctionnement d'un détecteur de proximité inductif, comprenant un capteur magnétique (9) et placé dans un boîtier métallique, selon l'une des revendications précédentes, dans lequel une impulsion d'émission de forme d'impulsion déterminée génère un champ magnétique primaire (5), une cible électriquement conductrice (6) est exposée au champ magnétique qui est détecté et évalué par le champ magnétique secondaire (7) généré par les courants de Foucault dans la cible (6), **caractérisé en ce que** la forme d'impulsion, et donc l'allure dans le temps du champ magnétique primaire (5), est adaptée à la fréquence de coupure du boîtier métallique agissant en tant que pour une meilleure pénétration du boîtier métallique et les composantes à basses fréquences, générées par les fronts d'impulsion, du champ magnétique secondaire (7) sont ainsi évaluées avec le capteur magnétique (9).
